# EUROPEAN PATENT APPLICATION

(11) **EP 2 416 393 A1**
(43) Date of publication of application: **08.02.2012**
(21) Application number: 10758382.5
(22) Date of filing: 03.03.2010
(51) Int. Cl.: H01L 51/42

(54) **ORGANIC THIN-FILM SOLAR CELL AND MANUFACTURING METHOD THEREFOR**

(30) Priority: 31.03.2009 JP 2009087080
(71) Applicant: LINTEC Corporation, Tokyo 173-0001 (JP)
(72) Inventor: LUO Yongchun, Tokyo 173-0001 (JP); IWAMOTO Yuko, Tokyo 173-0001 (JP); NAGAMOTO Koichi, Tokyo 173-0001 (JP); KONDO Takeshi, Tokyo 173-0001 (JP)
(74) Representative: Ablett, Graham Keith
(86) International application number: PCT/JP2010/053927
(87) International publication number: WO 2010/113606

(57) **Abstract**

Providing an organic thin-film solar cell that can be easily manufactured and then mass produced at low cost while increasing the photoelectric conversion efficiency, and the method of producing the same.

Solar cells 100-102 include at least one of a mixed P-type organic semiconductor layer 12M and a mixed N-type organic semiconductor layer 14M. A plurality of organic semiconductor materials are mixed in the mixed P-type organic semiconductor layer 12M or the mixed N-type organic semiconductor layer 14M, respectively. In such a way, the photoelectric conversion efficiency of the solar cells is increased by selecting and mixing proper organic semiconductor materials to form the organic semiconductor layer.

## Description

### TECHNICAL FIELD

The present invention relates to an organic thin-film solar cell, and particularly relates to an organic thin-film solar cell including an organic semiconductor layer utilizing a plurality of organic semiconductor materials and a method of producing the same.

### BACKGROUND ART

Various types of solar cells utilizing an organic semiconductor material are known. The examples include a dye-sensitized solar cell utilizing a photosensitization effect (for example, Patent Citations 1 and 2), and an organic thin-film solar cell having a tandem structure in which a plurality of semiconductor layers that are P-type or N-type doped and composed of a single material are stacked, respectively, (for example, Patent Citation 3), and so on.
Patent Citation 1: JAPANESE UNEXAMINED PATENT PUBLICATION (KOKAI) No.2000-195569
Patent Citation 2: JAPANESE UNEXAMINED PATENT PUBLICATION (KOKAI) No.2005-26051
Patent Citation 3: PUBLISHED PATENT APPLICATION, JAPANESE TRANSLATION OF PCT NATIONAL PUBLICATION OF THE TRANSLATED VERSION (Laid-open) No. 2006-520533

### DISCLOSURE OF INVENTION

### TECHNICAL PROBLEM

In the manufacture of a dye-sensitized solar cell, it is necessary that a dye layer composed of a predetermined dye is formed and made into a film, and then laminated on a semiconductor layer of titanium oxide and so on. Accordingly, it is difficult to manufacture the dye-sensitized solar cell with a simple manufacture process, and the structure of the completed dye-sensitized solar cell is complicated.

Further, in the organic thin-film solar cell having the tandem structure, a plurality of semiconductor layers of which materials are different from each other are laminated together to expand the solar-light absorption region. However, since many organic semiconductor layers are provided, it is difficult to select and stabilize an electrode film that is laminated between the organic semiconductor layers and the manufacturing process becomes complicated. The complicated nature of the manufacturing process is a factor which raises the cost for manufacturing the organic thin-film solar cell having the tandem structure.

Therefore, the object of the present invention is to provide an organic thin-film solar cell that can be easily manufactured to enable mass production at a low cost, while improving the photoelectric conversion efficiency, and the method of producing the same.

### TECHNICAL SOLUTION

An organic thin-film solar cell in the present invention comprises a P-type organic semiconductor layer and an N-type organic semiconductor layer. The organic thin-film solar cell is **characterized in that** at least one of the P-type organic semiconductor layer and N-type organic semiconductor layer comprises a mixture of a plurality of organic semiconductor materials of which absorption bands in the optical absorption spectrum are different from each other.

In the organic thin-film solar cell, it is preferable that a mixed layer comprising a mixture of a P-type organic semiconductor material and an N-type organic semiconductor material is further provided between the P-type organic semiconductor layer and the N-type organic semiconductor layer. Furthermore, it is preferable that the organic thin-film solar cell further comprises an electrode and a buffer layer, wherein the buffer layer is provided between the electrode and an organic semiconductor layer of at least one of the P-type organic semiconductor layer and the N-type organic semiconductor layer.

For example, the P-type organic semiconductor layer includes polyphenylene vinylene, polyphenylene vinylene derivative, polythiophene, phthalocyanine, phthalocyanine derivative, porphyrin, pentacene, or rubrene as the organic semiconductor material. Furthermore, the N-type organic semiconductor layer includes fullerene, fullerene derivative, carbon nanotube, or carbon nanotube derivative, as the organic semiconductor material, for example. Further, in the organic thin-film solar cell, at least one of the P-type organic semiconductor layer and the N-type organic semiconductor layer may be plurally stacked.

A method of producing an organic thin-film solar cell in the present invention is the method of producing the organic thin-film solar cell comprising a P-type organic semiconductor layer and an N-type organic semiconductor layer. The method of producing an organic thin-film solar cell in the present invention is **characterized in that** at least one of the P-type organic semiconductor layer and the N-type organic semiconductor layer is formed by mixing a plurality of organic semiconductor materials.

### ADVANTAGEOUS EFFECTS

The present invention can provide an organic thin-film solar cell which can be easily manufactured to enable mass production at a low cost while improving the photoelectric conversion efficiency, and method of producing the same.

### BRIEF DESCRIPTION OF DRAWINGS

Fig. 1 is a cross-section view which schematically shows an organic thin-film solar cell of a first embodiment.
Fig. 2 is a cross-section view which schematically shows an organic thin-film solar cell including a mixed layer in the first embodiment.
Fig. 3 is a cross-section view which schematically shows an organic thin-film solar cell including a mixed layer in a second embodiment.
Fig. 4 is a cross-section view which schematically shows an organic thin-film solar cell of the second embodiment.
Fig 5 is a view which shows the optical absorption spectrums of the standalone semiconductor materials and a mixture thereof.

### EXPLANATION OF REFERENCES

100-111 Solar Cell (Organic Thin-Film Solar Cell)
12 P-type Organic Semiconductor Layer
12M Mixed P-type Organic Semiconductor Layer
14 N-type Organic Semiconductor Layer
14M Mixed N-type Organic Semiconductor Layer
20 Mixed Layer

### EMBODIMENTS FOR CARRYING OUT INVENTION

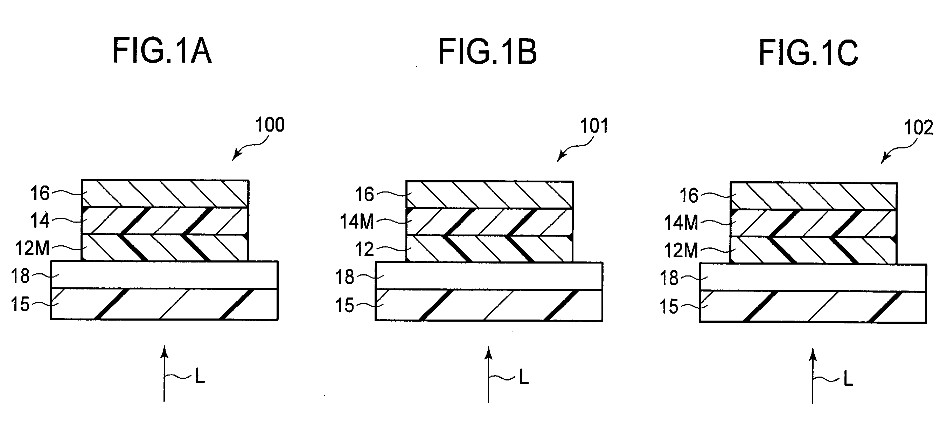

An organic thin-film solar cell in a first embodiment is explained below. Fig. 1 is a cross-section view which schematically shows the organic thin-film solar cell of the first embodiment. Furthermore, each layer composing the organic thin-layer solar cell is enlarged in the thickness direction in Fig. 1 and the following figures, for convenience of explanation.

Solar cells 100-102 of this embodiment, which are the organic thin-film solar cells, include a P-type organic semiconductor layer 12 or 12M and an N-type organic semiconductor layer 14 or 14M. The P-type and N-type organic semiconductor layers 12, 14 and so on are provided between an electrode 16 (anode) at the surface and a transparent electrode 18 (cathode) on a substrate 15. Thus, in the solar cells 100-102 of this embodiment, the transparent electrode 18 is provided on the substrate 15 side, and the P-type organic semiconductor layer 12 or 12M, the N-type organic semiconductor layer 14 or 14M, and the electrode 16 are stacked thereon in this order. Hereinafter, the structure of the solar cells 100-102 in this embodiment; namely, the structure in which the electrode 16 is disposed at the surface on the opposite side of the substrate 15 and the transparent electrode 18 is disposed on the substrate 15 side, will be called the "bottom-type".

In this embodiment, a main component of at least one of the P-type organic semiconductor layer and the N-type organic semiconductor layer is a mixture of a plurality of organic semiconductor materials. Namely, the solar cells of this embodiment include the solar cell 100 that has a mixed P-type organic semiconductor layer 12M that is formed by mixing a plurality of P-type organic semiconductor materials together in only the P-type organic semiconductor layer as shown in Fig. 1A; the solar cell 101 that has a mixed N-type organic semiconductor layer 14M that is formed by mixing a plurality of N-type organic semiconductor materials together in only the N-type organic semiconductor layer as shown in Fig. 1B; or the solar cell 102 that has the mixed P-type organic semiconductor layer 12M that is formed by mixing a plurality of P-type organic semiconductor materials and the mixed N-type organic semiconductor layer 14M that is formed by mixing a plurality of N-type organic semiconductor materials as shown in Fig. 1C.

In the solar cells 100-102, when light that is incident from the substrate 15 side as indicated by an arrow L reaches a contact face between the mixed P-type organic semiconductor layer 12M and the N-type organic semiconductor layer 14, between the P-type organic semiconductor layer 12 and the mixed N-type organic semiconductor layer 14M, or between the mixed P-type organic semiconductor layer 12M and the mixed N-type organic semiconductor layer 14M, pairs of holes and electrons are generated. And then, the hole transfers to the P-type organic semiconductor layer 12 or the mixed P-type organic semiconductor layer 12M side and the electron transfers to the N-type organic semiconductor layer 14 or the mixed N-type organic semiconductor layer 14M side, so that the electric current flows.

The P-type organic semiconductor material included in the P-type organic semiconductor layer is not particularly limited as long as the carrier that produces the electric conduction is mainly hole, but polyphenylene vinylene (PPV); polyphenylene vinylene derivatives such as poly[2-methoxy-5-(3',7'-dimethyloctyloxy)-1,4-phenylene vinylene](MDMO-PPV), poly[2-methoxy-5-(2-ethylhexyloxy) -1,4-phenylene vinylene] (MEH-PPV), and so on; polythiophene derivatives such as poly-3-hexylthiophene (P3HT), poly-3-octylthiophene (P30T), poly-3-dodecylthiophene (P3DDT), and so on; phthalocyanine; phthalocyanine derivatives such as copper phthalocyanine, zinc phthalocyanine, titanyl Phthalocyanine, and so on; porphyrin; pentacene; and rubrene are preferable. The mixed P-type organic semiconductor layer 12M is formed by mixing a plurality of organic semiconductor materials, selected from these P-type organic semiconductor materials, whose absorption bands in optical absorption spectrum are different from each other. The P-type organic semiconductor layer 12 is formed by one of these P-type organic semiconductor materials. Further, the plurality of P-type organic semiconductor materials included in the mixed P-type organic semiconductor layer 12M can be mixed at an arbitrary rate, but a P-type organic semiconductor material that represents the smallest portion included in such a layer is not less than 10 mol%, based on the total of the P-type organic semiconductor materials in the mixed P-type organic semiconductor layer 12M.

The N-type organic semiconductor material included in the N-type organic semiconductor layer 14M is not particularly limited as long as the carrier that produces the electric conduction is mainly electron, but fullerene, fullerene derivatives such as [6,6]-phenyl-C₆₁-butyric acid methyl ester (PCBM), carbon nanotube, and carbon nanotube derivatives are preferable. The mixed N-type organic semiconductor layer 14M is formed by mixing a plurality of organic semiconductor materials, selected from these N-type organic semiconductor materials, whose absorption bands of the optical absorption spectrum are different from each other. The N-type organic semiconductor layer 14 is formed by one of these P-type organic semiconductor materials. Further, the plurality of N-type organic semiconductor materials included in the mixed N-type organic semiconductor layer 14M can be mixed at an arbitrary rate.

The thickness of the P-type organic semiconductor layer 12, the mixed P-type organic semiconductor layer 12M, the N-type organic semiconductor layer 14, and the mixed N-type organic semiconductor layer 14M is generally from 5 to 500 nm, and is preferably from 10 to 100 nm. Further, as the substrate 15, the transparent electrode 18, and electrode 16 that are utilized in this embodiment, the materials that constitute the known organic thin-film solar cell can be used. Examples for the substrate 15 include glass, synthetic resin film, and so on, which are transparent; examples for the electrode 16 include a film composed of metal such as gold, silver, copper, aluminum, and so on; and examples for the transparent electrode 18 include tin-doped indium oxide (ITO), tin oxide, zinc oxide, and so on.

The P-type and N-type organic semiconductor layers, or either one of these are formed by the mixture of a plurality of organic semiconductor materials whose absorption bands in optical absorption spectrum are different from each other, which can increase the photoelectric conversion efficiency of the solar cell as described below. Moreover, the structure of the solar cell is simpler in this embodiment, compared to the case where it is intended to increase the photoelectric conversion efficiency with the tandem structure in which a P-type organic semiconductor layer including one P-type organic semiconductor material and an N-type organic semiconductor layer including one N-type organic semiconductor material are stacked in plural layers. The reason is that the photoelectric conversion efficiency can be increased with only two layers: the P-type organic semiconductor layer and the N-type organic semiconductor layer.

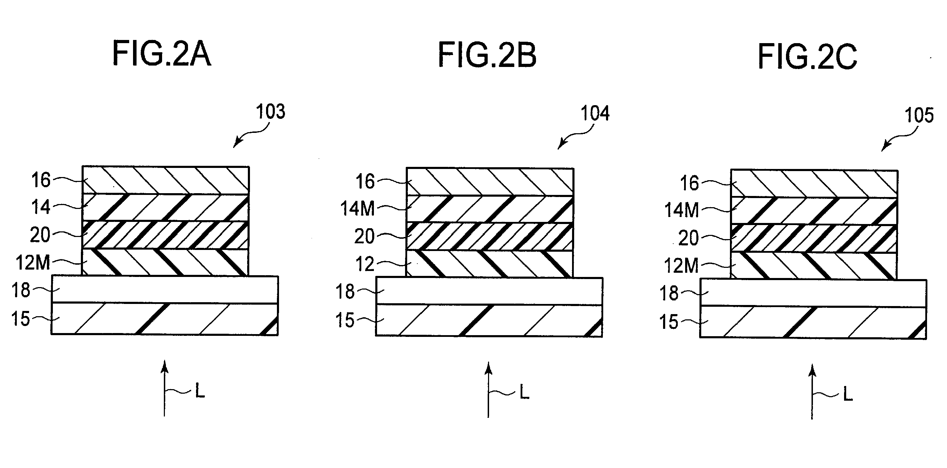

The bottom-type solar cell may be a solar cell 103 in which a mixed layer 20 is provided between the mixed P-type organic semiconductor layer 12M and the N-type organic semiconductor layer 14; a solar cell 104 in which a mixed layer 20 is provided between the P-type organic semiconductor layer 12 and the mixed N-type organic semiconductor layer 14M; or a solar cell 105 in which a mixed layer 20 is provided between the mixed P-type organic semiconductor layer 12M and the mixed N-type organic semiconductor layer 14M, as shown in Figs. 2A-2C. Here, the substrate 15, the transparent electrode 18, the P-type organic semiconductor layer 12, the mixed P-type organic semiconductor layer 12M, the N-type organic semiconductor layer 14, the mixed N-type organic semiconductor layer 14M, and the electrode 16 are similar to those in the solar cells 100-102 described above. Further, in Fig. 2 and the following, components which are the same or correspond to those in the solar cells 100-102 of the first embodiment are labeled by the same references as in Fig. 1.

The mixed layer 20 includes a P-type organic semiconductor material and an N-type organic semiconductor material, and it is preferable that the P-type organic semiconductor material and the N-type organic semiconductor material are mixed in equal amounts (molar number). As for the P-type organic semiconductor material and the N-type organic semiconductor material, one or a plurality of materials may be used. Further, in regard to the P-type organic semiconductor material and the N-type organic semiconductor material, materials similar to those described above can be used.

As described, the photoelectric conversion efficiency of the solar cell can be increased by providing the mixed layer 20 between the (mixed) P-type organic semiconductor layer and the (mixed) N-type organic semiconductor layer. The reason is that it can create the PN junction between the P-type and N-type organic semiconductors on the molecular level in the mixed layer 20.

Moreover, a buffer layer (not shown in Figs.) may be further stacked in the bottom-type solar cells 100-105. The buffer layer is provided between an electrode and an organic semiconductor layer of at least one of the P-type organic semiconductor layer and the N-type organic semiconductor layer, but it is generally provided between the N-type organic semiconductor layer 14 or the mixed N-type organic semiconductor layer 14M and the electrode 16, and between the P-type organic semiconductor layer 12 or the mixed P-type organic semiconductor layer 12M and the transparent electrode 18.

Examples of the buffer layer that is provided between the N-type organic semiconductor layer 14 and the electrode 16 or between the mixed N-type organic semiconductor layer 14M and the electrode 16 include BCP (bathocuproine; 2,9-dimetyl-4,7-diphenyl-1,10-phenanthroline), which is as a hole-blocking material. Examples of the buffer layer that is provided between the P-type organic semiconductor layer 12 and the transparent electrode 18 or between the mixed P-type organic semiconductor layer 12M and the transparent electrode 18 include PEDOT:PSS (a complex of poly (3,4-ethylenedioxythiophene) and poly(4-styrenesulfonate)), MoO₃ (molybdenum trioxide), and so on. The performance of the solar cells 100-105 can be further improved by providing such a buffer layer.

Further, both the mixed layer 20 described above (refer to Figs. 2A-2C) and the buffer layer (not shown in Figs.) may be provided in the bottom-type solar cells 100-105. In this case, both of the above-mentioned effects that are produced by the mixed layer 20 and buffer layer can be obtained.

The method of producing the solar cells 100-105 is not particularly limited, but the solar cell can be produced by laminating the transparent electrode 18, the mixed P-type organic semiconductor layer 12M, the P-type organic semiconductor layer 12, the mixed N-type organic semiconductor layer 14M, the N-type organic semiconductor layer 14, the electrode 16, the mixed layer 20, the buffer layer and/or others, on the substrate 15 in accordance with the intended structure of the solar cell, for example. The method of lamination is appropriately selected depending on the laminated material. For example, the electrode 16 and the transparent electrode 18 can be formed by vacuum deposition, sputtering, or others. The mixed P-type organic semiconductor layer 12M, the P-type organic semiconductor layer 12, the mixed N-type organic semiconductor layer 14M, the N-type organic semiconductor layer 14, the mixed layer 20, and the buffer layer can be formed by vacuum deposition, spin coating, or others. For forming the mixed P-type organic semiconductor layer 12M, the mixed N-type organic semiconductor layer 14M and the mixed layer 20, co-evaporation, or spin coating using a solution including two or more kinds of materials may be done. Further, after laminating, sealing by a glass cap and so on is preferred in order to prevent degradation from moisture and so on.

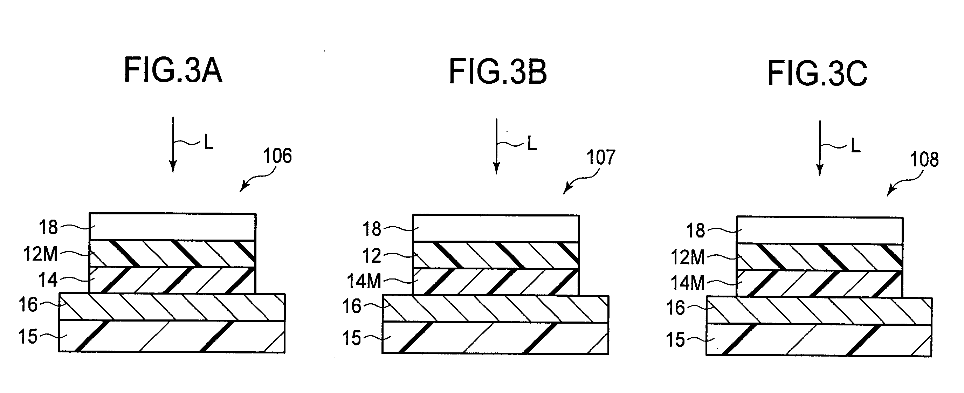

Next, an organic thin-film solar cell in a second embodiment, mainly the differences from that in the first embodiment, will be explained. Fig. 3 is a cross-section view which schematically shows the organic thin-film solar cells 106-108 of the second embodiment.

The organic thin-film solar cells 106-108 of the second embodiment have a structure wherein the electrode 16 is disposed on the substrate 15 side and the transparent electrode 18 is disposed at the surface on the opposite side of the substrate 15, and the light L is incident from the transparent electrode 18 side. Hereinafter, such a structure of the solar cells 106-108 in this embodiment is called the "top-type". As shown in Figs. 3A-3C, in the solar cells 106-108 of this embodiment, at least one of the mixed P-type organic semiconductor layer 12M and the mixed N-type organic semiconductor layer 14M is provided also.

Accordingly, the photoelectric conversion efficiency of the solar cell in this embodiment can also be increased. Furthermore, the top-type solar cells 106-108, in which the arrangement of the layer members is the only difference from the structure of the bottom-type, have a simple structure similar to the bottom-type.

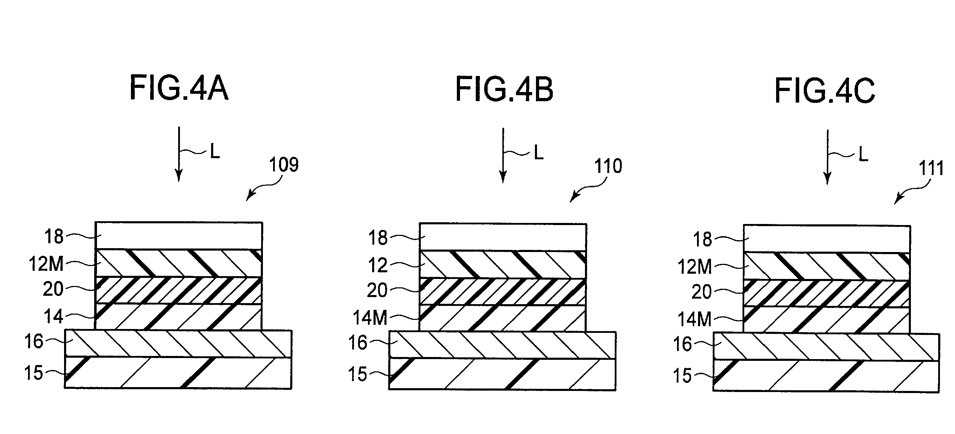

Also in the top-type solar cell, the mixed layer 20 may be further stacked between the mixed P-type organic semiconductor layer 12M and the N-type organic semiconductor layer 14, between the P-type organic semiconductor layer 12 and the mixed N-type organic semiconductor layer 14M, and between the mixed P-type organic semiconductor layer 12M and the mixed N-type organic semiconductor layer 14M, respectively, as in the solar cells 109-111 shown in Figs. 4A-4C, in order to increase the photoelectric conversion efficiency. Of course, the buffer layer may be provided in the top-type solar cells 106-111, similar to the bottom-type solar cells 100-105.

For the mixed P-type organic semiconductor layer 12M, the P-type organic semiconductor layer 12, the mixed N-type organic semiconductor layer 14M, the N-type organic semiconductor layer 14, the substrate 15, the electrode 16, the transparent electrode 18, the mixed layer 20, and the buffer layer in this embodiment, the materials similar to one which is explained in the first embodiment can be used, but the substrate 15 does not need to be transparent. Further, the solar cells 106-111 of this embodiment can be produced with the method similar to one that is explained in the first embodiment.

The materials and the structures of the solar cells 100-111 are not limited to those in the above-mentioned embodiments. For example, any component with the exception of organic semiconductor materials may be added in appropriate amounts to a semiconductor layer such as the mixed P-type organic semiconductor layer 12M, the mixed N-type organic semiconductor layer 14M, the P-type organic semiconductor layer 12, and the N-type organic semiconductor layer 14. Further, two buffer layers may be provided (namely, with one positioned between the transparent electrode 18 and either the P-type organic semiconductor layer 12 or the mixed P-type organic semiconductor layer 12M, and other positioned between either the N-type organic semiconductor layer 14 or the mixed N-type organic semiconductor layer 14M and the electrode 16; refer to Figs. 1-4) as described above; however the buffer layer may be provided with only one of these.

The method for producing the organic thin-film solar cell is not limited to those shown in the above-mentioned embodiments. Namely, mixing the organic semiconductor materials may be done by utilizing a method other than co-evaporation, and spin coating using the mixed solution. For example, the mixed P-type organic semiconductor layer 12M and the mixed N-type organic semiconductor layer 14M may be formed with ink-jet, gravure print, or others.

Moreover, the solar cells 100-111 can be made in a tandem structure. For example, in the above-mentioned solar cells 100-111 including at least one of the mixed P-type organic semiconductor layer 12M and the mixed N-type organic semiconductor layer 14M, two or more layers of at least one same layer-type of either P-type organic semiconductor layer 12, N-type organic semiconductor layer 14, mixed P-type organic semiconductor layer 12M or mixed N-type organic semiconductor layer 14M may be stacked so as to form the tandem structure.

### (Examples)

Next, the solar cell of this invention will be explained by Examples, but the present invention is not limited to these Examples.

### [Working Example 1]

A thin-film (mixed P-type organic semiconductor layer 12M) having a thickness of 20nm was formed on the surface of the ITO (transparent electrode 18) of a glass substrate patterned with ITO (thickness 0.7mm, planar dimension 25mm×25mm, thickness of ITO 150nm, manufactured by Sanyo Vacuum Industries Co., Ltd.) using three P-type organic semiconductor materials: CuPc (copper phthalocyanine), ZnPc (zinc phthalocyanine) and TiOPc (titanyl Phthalocyanine) (all manufactured by Ohjec Corporation); in equal amounts (molar number) by vacuum deposition (co-evaporation).

Moreover, a thin-film (N-type organic semiconductor layer 14) of fullerene (expressed as "C60") which is an N-type organic semiconductor material, having a thickness of 30nm was formed on the mixed P-type organic semiconductor layer 12M by vacuum deposition. Next, an BCP layer (buffer layer) as a hole-blocking member having thickness of 10nm was formed on the N-type organic semiconductor layer 14 by vacuum deposition, and then, a film of metal silver having thickness of 100nm was formed thereon as an electrode 16 by vacuum deposition. Finally, this multi-layer structure was sealed by a glass cap to obtain a solar cell of Working Example 1.

### [Comparative Example 1]

A solar cell was manufactured in a manner similar to that in Working Example 1, except for using only CuPc as the P-type organic semiconductor material in Comparative Example 1. The structures of the solar cells in Working Example 1 and Comparative Example 1 are described briefly as follows.
Working Example 1: ITO/(CuPc+ZnPc+TiOPc) (20nm) /C60 (30nm)/BCP (10nm)/ Ag (100nm)
Comparative Example 1: ITO/CuPc (20nm) / C60 (30nm)/BCP (10nm)/ Ag (100nm)

In such a way, while the mixed P-type organic semiconductor layer 12M was formed using CuPc, ZnPc and TiOPc by co-evaporation in the solar cell of Working Example 1, the P-type organic semiconductor 12 was formed from only CuPc in Comparative Example 1. Further, in both Working Example 1 and Comparative Example 1, the N-type organic semiconductor 14 was formed using C60 only as the N-type organic semiconductor material.

### [Working Example 2]

A thin-film (mixed P-type organic semiconductor layer 12M) having a thickness of 20nm was formed on the surface of the ITO (transparent electrode 18) of a glass substrate which was the same as that in Working Example 1, using P-type organic semiconductor materials: CuPc and TiOPe (both manufactured by Ohjec Corporation) in equal amounts (molar number) by vacuum deposition (co-evaporation).

Moreover, a thin-film (mixed layer 20) having a thickness of 30nm was formed on the mixed P-type organic semiconductor layer 12M by vacuum deposition (co-evaporation), using three materials, CuPc and TiOPc, which are the P-type organic semiconductor materials, and C60, which is the N-type organic semiconductor material. In this case, the amounts of CuPc, TiOPc and C60 were in CuPc TiOPc C60 = 0.5:0.5:1 (molar ratio). Namely, the total amount (mole number) of P-type organic semiconductor materials, CuPc and TiOPc, was made to be equal to that of the N-type organic semiconductor material, C60. Next, an N-type organic semiconductor layer 14 utilizing only C60 as the N-type organic semiconductor material, a BCP layer (buffer layer) and a film of an electrode 16 of metal silver were formed on the mixed layer 20 and then sealed by a glass cap, similar to in Working Example 1. In such a way, a solar cell of Working Example 2 was obtained.

### [Comparative Example 2]

A solar cell was manufactured in a manner similar to that in Working Example 2, except for using only CuPc as the P-type organic semiconductor material and using CuPc and C60 of which amount (molar number) was the same as that of CuPc, as the ingredients of the mixed layer 20, in Comparative Example 2.The structures of the solar cells of Working Example 2 and Comparative Example 2 are described briefly as follows.
Working Example 2: ITO/(CuPc+TiOPc) (20nm)/[(CuPc+TiOPc) +C60] (30nm)/C60 (30nm) /BCP (10nm)/ Ag (100nm)
Comparative Example 2: ITO/CuPc (20nm) /(CuPc+C60) (30nm)/ C60 (30nm) /BCP (10nm)/ Ag (100nm)

In such a way, while the mixed P-type organic semiconductor layer 12M was formed using CuPc and TiOPc by co-evaporation in the solar cell of Working Example 2, the P-type organic semiconductor 12 was formed from only CuPc in Comparative Example 2. Further, in Comparative Example 2, only CuPc was used as the P-type organic semiconductor material in the mixed layer utilized in the P-type organic semiconductor layer.

### [Working Example 3]

Aqueous dispersion of polythiophene conductive polymer PEDOT:PSS (manufactured by Bayer, product name: Baytron P) was applied onto the surface of the ITO (transparent electrode 18) of a glass substrate, which was the same as that in Working Example 1, with spin coating and then dried at 140°C for 30 minutes so as to form a film having a thickness of 50nm as a buffer layer. Next, a chlorobenzene solution (4 mass % of the total contents of P3HT and P30T) in which P-type organic semiconductor materials, P3HT (poly-3-hexylthiophene) and P30T (poly-3-octylthiophene; both manufactured by Ohjec Corporation), were mixed in equal amounts (molar number) was applied onto the buffer layer with spin coating and then dried at 150°C for 10 minutes so that a mixed P-type organic semiconductor layer 12M having a thickness of 50nm was formed.

Moreover, a chlorobenzene solution (4 mass % of the total contents of P3HT, P30T and PCBM) including P-type organic semiconductor materials, P3HT and P30T, and an N-type organic semiconductor material, PCBM ([6,6]-phenyl-C₆₁-butyric acid methyl ester), was applied onto the mixed P-type organic semiconductor layer 12M with spin coating and then dried at 150°C for 10 minutes so that a thin-film (mixed layer 20) having a thickness of 50nm was formed. In this case, the amounts of P3HT, P30T and PCBM were P3HT:P30T:PCBM = 0.5:0.5:1 (molar ratio). Namely, the total amount of P-type organic semiconductor materials, P3HT and P30T, was made to be equal (mole number) to that of the N-type organic semiconductor material, PCBM. Next, a chlorobenzene solution of PCBM was applied onto the mixed layer 20 with spin coating and then dried at 150°C for 10 minutes so that an N-type organic semiconductor layer 14 having a thickness of 40nm was formed. A film of metal aluminum, which was an electrode 16, was formed on the N-type organic semiconductor layer 14 and then sealed by a glass cap. In this way, a solar cell of Working Example 3 was obtained.

### [Comparative Example 3]

A solar cell was manufactured in a manner similar to that in Working Example 3, except for using only P3HT as the P-type organic semiconductor material and using P3HT and PCBM of which the amount (molar number) was the same as that of P3HT, as the ingredients of the mixed layer, in Comparative Example 3. The structures of the solar cells in Working Example 3 and Comparative Example 3 are described briefly as follows.
Working Example 3: ITO /PEDOT:PSS (50nm)/(P3HT+P30T) (50nm)/ [(P3HT+P30T)+PCBM] 50nm) /PCBM (40nm) /Al (100nm)
Comparative Example 3: ITO /PEDOT:PSS (50nm)/ P3HT (50nm) /(P3HT+PCBM)(50nm) /PCBM (40nm) / Al (100nm)

In such a way, while the mixed P-type organic semiconductor layer 12M was formed of P3HT and P30T in the solar cell of Working Example 3, the P-type organic semiconductor 12 was formed of P3HT only in Comparative Example 3. Further, in Working Example 3 and Comparative Example 3, the ingredients of the mixed layer were adjusted in accordance with the materials of the P-type organic semiconductor layer.

### [Working Example 4]

Aqueous dispersion of polythiophene conductive polymer, PEDOT:PSS (manufactured by Bayer, product name: Baytron P) was applied onto the surface of the ITO (transparent electrode 18) of a glass substrate, which was the same as that in Working Example 1, with spin coating and then dried at 140°C for 30 minutes so as to form a film having a thickness of 50nm as a buffer layer. Next, a chlorobenzene solution (4 mass % of the total contents of P3HT and MDMO-PPV) in which the P-type organic semiconductor materials, P3HT and MDMO-PPV (poly[2-methoxy-5-(3',7'-dimethyloctyloxy)-1,4-phenylene vinylene]; all manufactured by Ohjec Corporation), were mixed in equal amounts (molar number) were applied onto the buffer layer with spin coating and then dried at 150°C for 10 minutes so that a mixed P-type organic semiconductor layer 12M having a thickness of 50nm was formed.

Moreover, a chlorobenzene solution (4 mass % of the total contents of P3HT, MDMO-PPV and PCBM) including P-type organic semiconductor materials, P3HT and MDMO-PPV, and an N-type organic semiconductor material, PCBM ([6,6]-phenyl-C₆₁-butyric acid methyl ester) was applied onto the mixed P-type organic semiconductor layer 12M with spin coating and then dried at 150°C for 10 minutes so that a thin-film (mixed layer 20) having a thickness of 80nm was formed. In this case, the amounts of P3HT, MDMO-PPV and PCBM were P3HT: MDMO-PPVT:PCBM = 0.5:0.5:1 (molar ratio). Namely, the total amount of P-type organic semiconductor materials, P3HT and MDMO-PPV, was made to be equal (mole number) to that of N-type organic semiconductor material, PCBM. Next, a chlorobenzene solution of PCBM (4 mass % contents)was applied onto the mixed layer 20 with spin coating and then dried at 150°C for 10 minutes so that an N-type organic semiconductor layer 14 having a thickness of 40nm was formed. Metal aluminum was formed into a film having a thickness of 120nm on the N-type organic semiconductor layer 14 as an electrode 16 with vacuum deposition and then sealed by a glass cap. In this way, a solar cell of Working Example 4 was obtained.

### [Comparative Example 4]

A solar cell was manufactured in a manner similar to that in Working Example 4, except for using only P3HT as the P-type organic semiconductor material and using P3HT and PCBM, of which the amount (molar number) was the same as that of P3HT, as the ingredients of the mixed layer in Comparative Example 4. The structures of the solar cells of Working Example 4 and Comparative Example 4 were described briefly as follows.
Working Example 4: ITO /PEDOT PSS(50nm)/(P3HT+MDMO-PPV) (50nm)/ [(P3HT+MDMO-PPV)+PCBM] (80nm)/PCBM(40nm)/Al(120nm)
Comparative Example 4 ITO /PEDOT PSS(50nm)/P3HT (50nm)/ (P3HT+PCBM) (80nm) / PCBM(40nm) /Al(120nm)

### [Working Example 5]

Aluminum was vacuum-deposited on a glass substrate (thickness 0.7mm, planar dimension 25mm×25mm) so as to form an anode 16 having a thickness of 100nm. A chlorobenzene solution of PCBM, which is an N-type organic semiconductor material, was applied onto the surface of the anode 16 with spin coating and then dried at 150°C for 10 minutes so that an N-type organic semiconductor layer 14 having a thickness of 40nm was formed.

Moreover, a chlorobenzene solution (4 mass % of the total contents of P3HT, P2HT and PCBM) including P-type organic semiconductor materials, P3HT and P30T (both manufactured by Ohjec Corporation), and an N-type organic semiconductor material, PCBM was applied onto the N-type organic semiconductor layer 14 with spin coating and then dried at 150°C for 10 minutes so that a thin-film (mixed layer 20) having a thickness of 80nm was formed. In this case, the amounts of P3HT, P2HT and PCBM were P3HT: P30T:PCBM = 0.5:0.5:1 (molar ratio). Namely, the total amount of the P-type organic semiconductor materials, P3HT and P30T, was made to be equal (mole number) to that of the N-type organic semiconductor material, PCBM.

Next, a chlorobenzene solution (4 mass % of the total contents of P3HT and P30T), in which P-type organic semiconductor materials P3HT and P30T were mixed in equal amounts (molar number), was applied onto the mixed layer 20 with spin coating and then dried at 150°C for 10 minutes so that a mixed P-type organic semiconductor layer 12M having a thickness of 50nm was formed.

Aqueous dispersion of polythiophene conductive polymer PEDOT:PSS (manufactured by Bayer, product name: Baytron P) was applied onto the mixed P-type organic semiconductor layer 12M with spin coating and then dried at 140°C for 30 minutes so as to form a layer of PEDOT:PSS having a thickness of 50nm, and then a layer of MoO₃ having a thickness of 3nm was provided thereon with a vacuum deposition method. The layer of PEDOT:PSS and the layer of MoO₃ are a buffer layers. A film of ITO was formed on the layer of MoO₃ with sputtering, so as to form a film of transparent electrode 18 having a thickness of 150nm, and then sealed by a glass cap. In this way, a solar cell (top-type) of Working Example 5 was obtained.

### [Comparative Example 5]

A solar cell was manufactured in a manner similar to that in Working Example 5, except for using only P3HT as the P-type organic semiconductor material and using P3HT and PCBM, of which the amount (molar number) was the same as that of P3HT, as the ingredients of the mixed layer in Comparative Example 5. The structures of the solar cells in Working Example 5 and Comparative Example 5 are described briefly as follows.
Working Example 5: Al(100nm) / PCBM(40nm) /[(P3HT+P30T)+PCBM](80nm)/ P3HT+P30T(50nm) / PEDOT PSS 50nm)/MoO₃(3nm)/ ITO(150nm)
Comparative Example 5 Al(100nm) / PCBM(40nm) /(P3HT+PCBM)(80nm)/ P3HT(50nm)/ PEDOT PSS(50nm)/MoO₃ (3nm)/ ITO(150nm)

### [Working Example 6]

Silver was vacuum-deposited on a glass substrate (thickness 0.7mm, planar dimension 25mm×25mm) so as to form an anode 16 having a thickness of 100nm. A BCP layer having thickness of 10nm was formed as a hole-blocking member on the surface of the anode 16 with vacuum deposition. An N-type organic semiconductor material, Fullerene (C60), was vacuum-deposited into a film on the BCP layer so as to form the N-type organic semiconductor layer 14 having a thickness of 30nm. Next, a mixed P-type organic semiconductor layer 12M having a thickness of 20nm was formed on the N-type organic semiconductor layer 14 using three P-type organic semiconductor materials, CuPc (copper phthalocyanine), ZnPc (zinc phthalocyanine) and TiOPc (titanyl Phthalocyanine) (all manufactured by Ohjec Corporation) in equal amounts (molar number) by vacuum deposition. A layer of MoO₃ having thickness of 3nm was formed on the mixed P-type organic semiconductor layer 12M with vacuum deposition as a buffer layer. Next, a layer of ITO was formed on the layer of MoO₃ with sputtering, so as to form a film of the transparent electrode 18 having thickness of 150nm and then sealed by a glass cap. In this way, a solar cell (top-type) of Working Example 6 was obtained.

### [Comparative Example 6]

A solar cell was manufactured in a manner similar to that in Working Example 6, except for using CuPc only as the P-type organic semiconductor material in Comparative Example 6. The structures of the solar cells in Working Example 6 and Comparative Example 6 are described briefly as follows.
Working Example 6: Ag(100nm) /BCP(10nm) /C60(30nm)/CuPc+ZnPc+TiOPc(20nm)/ MoO₃(3nm)/ ITO(150nm)
Comparative Example 6 Ag(100nm)/ BCP(10nm)/ C60(30nm)/CuPc(20nm)/ MoO₃(3nm)/ ITO(150nm)

Next, the performance of the solar cells of Working Examples 1-6 and Comparative Examples 1-6 will be explained. The photoelectric conversion efficiency and so on were measured by irradiating a pseudo solar light (AM1.5) onto an effective device area of 5.25mm² in the solar cells of Working Examples 1-6 and Comparative Examples 1-6 described above. Tables 1 and 2 show the results in this case. Further, the progress rate of the conversion efficiency was calculated by the following formula comparing Working Example 1 and Comparative Example 1, Working Example 2 and Comparative Example 2, Working Example 3 and Comparative Example 3, Working Example 4 and Comparative Example 4, Working Example 5 and Comparative Example 5, and Working Example 6 and Comparative Example 6, respectively.

Progress Rate of Conversion Efficiency (%) = {(Conversion Efficiency in Working Example - Conversion Efficiency in Comparative Example) / (Conversion Efficiency in Comparative Example)} × 100

**[Table 1]**

| | Work. Ex. 1 | Comp. Ex. 1 | Work. Ex. 2 | Comp. Ex. 2 | Work. Ex. 3 | Comp. Ex. 3 |
|---|---|---|---|---|---|---|
| Open Voltage (V) | 0.51 | 0.50 | 0.51 | 0.49 | 0.62 | 0.61 |
| Short-Circuit Current Density (mA/cm²) | 6.20 | 5.86 | 7.49 | 6.94 | 8.95 | 8.69 |
| Fill Factor | 0.47 | 0.45 | 0.48 | 0.45 | 0.41 | 0.41 |
| Conversion Efficiency (%) | 1.48 | 1.32 | 1.83 | 1.53 | 2.28 | 2.17 |
| Progress Rate of Conversion Efficiency (%) | 12 | | 20 | | 5.1 | |

**[Table 2]**

| | Work. Ex. 4 | Comp. Ex. 4 | Work. Ex. 5 | Comp. Ex. 5 | Work. Ex. 6 | Comp. Ex. 6 |
|---|---|---|---|---|---|---|
| Open Voltage (V) | 0.65 | 0.61 | 0.45 | 0.43 | 0.49 | 0.45 |
| Short-Circuit Current Density (mA/cm²) | 8.45 | 8.21 | 7.40 | 6.87 | 5.46 | 5.22 |
| Fill Factor | 0.43 | 0.41 | 0.37 | 0.38 | 0.35 | 0.34 |
| Conversion Efficiency (%) | 2.36 | 2.05 | 1.23 | 1.12 | 0.94 | 0.81 |
| Progress Rate of Conversion Efficiency (%) | 15 | - | 10 | - | 16 | - |

From these results, it was recognized that the solar cells of Working Examples 1-6 have better performance than the corresponding Comparative Examples 1-6, respectively. The reason is that the short-circuit current density was higher, so the photoelectric conversion efficiency was better in all Working Examples compared to their corresponding Comparative Examples, although no large differences regarding the open voltage and the fill factor were shown. In detail, the photoelectric conversion efficiency was improved by 5% (comparison between Working Example 3 and Comparative Example 3) to 20% (comparison between Working Example 2 and Comparative Example 2).

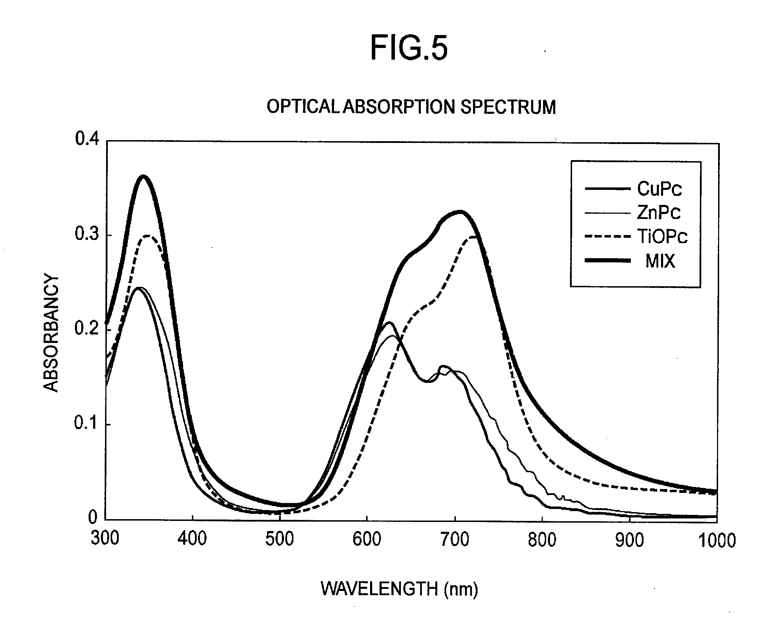

The reasons why the solar cells of Working Examples 1-6, in accordance with the above-mentioned embodiment, had the better photoelectric conversion efficiency as described above are as follows. In the Example of optical absorption spectrums of CuPc, ZnPc and TioPc (refer to Fig. 5), the absorption band (absorption wavelength region) of TiOPc is substantially different from those of CuPc and ZnPc. Accordingly, in the P-type organic semiconductor layer 12 formed from only one of CuPc, ZnPc or TioPc, a wavelength region of low absorbancy is present. For example, it is a long-wavelength region that is greater than or equal to 700nm in the case of using CuPc or ZnPc only, or a wavelength region of 550-600nm in case of using TiOPc only.

Contrastingly, in the mixture in which CuPc, ZnPc and TiOPc, of which the optical absorption spectrums are different from each other, are mixed in equal amounts, the wavelength region of low absorbancy is reduced by overlapping their absorption regions. Accordingly, the solar light can be absorbed more efficiently in the case of using such a mixture, than in the case of using only one. This is obvious from the evidence of Working Example 1 using the mixture to form the mixed P-type organic semiconductor layer 12M displaying the higher photoelectric conversion efficiency than Comparative Example 1 using CuPc only.

Furthermore, the efficient electric generation can be achieved when the mixed N-type organic semiconductor layer 14M is formed by selecting a plurality of organic semiconductor materials appropriately, as well as in the case of the mixed P-type organic semiconductor layer 12M.

As described above, selecting a plurality of proper organic semiconductor materials, mixing these and then forming the mixed P-type or N-type organic semiconductor layers 12M or 14M can increase the photoelectric conversion efficiency of the solar cell, according to the present embodiments. Furthermore, the photoelectric conversion efficiency can be increased by only two layers, such as the mixed P-type and mixed N-type organic semiconductor layers 12M and 14M and so on, and the structure of solar cell becomes simpler than the case in which the photoelectric conversion efficiency is improved by stacking a plurality of P-type and N-type organic semiconductor layers comprising components that are different from each other. This enables mass-production at low cost of the solar cell having the excellent photoelectric conversion efficiency.

## Claims

1. An organic thin-film solar cell comprising a P-type organic semiconductor layer and an N-type organic semiconductor layer, at least one of said P-type organic semiconductor layer and said N-type organic semiconductor layer comprising a mixture of a plurality of organic semiconductor materials of which absorption bands in an optical absorption spectrum are different from each other.

2. The organic thin-film solar cell as claimed in claim 1, wherein a mixed layer comprising a mixture of a P-type organic semiconductor material and an N-type organic semiconductor material is further provided between said P-type organic semiconductor layer and said N-type organic semiconductor layer.

3. The organic thin-film solar cell as claimed in claim 1 or 2, further comprising an electrode and a buffer layer, wherein said buffer layer is provided between said electrode and an organic semiconductor layer of at least one of said P-type organic semiconductor layer and said N-type organic semiconductor layer.

4. The organic thin-film solar cell as claimed in any of claims 1 to 3, wherein said P-type organic semiconductor layer includes polyphenylene vinylene, polyphenylene vinylene derivative, polythiophene, phthalocyanine, phthalocyanine derivative, porphyrin, pentacene, or rubrene as said organic semiconductor material.

5. The organic thin-film solar cell as claimed in any of claims 1 to 4, wherein said N-type organic semiconductor layer includes fullerene, fullerene derivative, carbon nanotube, or carbon nanotube derivative as said organic semiconductor material.

6. The organic thin-film solar cell as claimed in any of claims 1 to 5, wherein at least one of said P-type organic semiconductor layer and said N-type organic semiconductor layer is plurally stacked.

7. A method of producing an organic thin-film solar cell comprising a P-type organic semiconductor layer and an N-type organic semiconductor layer, comprising a step of forming at least one of said P-type organic semiconductor layer and said N-type organic semiconductor layer by mixing a plurality of organic semiconductor materials.
